# EUROPEAN PATENT APPLICATION

(11) **EP 4 687 005 A1**
(43) Date of publication of application: **04.02.2026**
(21) Application number: 24205377.5
(22) Date of filing: 08.10.2024
(51) Int. Cl.: G06F 1/20, H05K 7/14

(54) **LIQUID COOLING FOR PLUGGABLE MODULES**

(30) Priority: 29.07.2024 US 202418787607
(71) Applicant: Hewlett Packard Enterprise Development LP, Houston, TX 77070 (US)
(72) Inventor: LUNSMAN, Harvey John, Spring, TX, 77389 (US); DEAN, J. Steven, Spring, TX, 77389 (US); FERRER, Ernesto Juan, Spring, TX, 77389 (US); NELSON, Sydney Michelle, Spring, TX, 77389 (US)
(74) Representative: Fleuchaus & Gallo Partnerschaft mbB

(57) **Abstract**

An information processing system comprises a chassis defining a bay, a system board supported by the chassis, and a local liquid cooling subsystem supported by the chassis. The local liquid cooling subsystem is configured to circulate liquid coolant through the information processing system and comprises a cooling interface block thermally coupled to the liquid coolant. The cooling interface block comprising a slot. The system also comprises a pluggable module removably received in the bay. The pluggable module comprises a heat transfer assembly comprising a tab. The tab is removably received in the slot of the cooling interface block. The system also comprises a cooling interface module disposed in the slot between the tab and walls of the slot. The cooling interface module comprising a gap pad and a thermally conductive protective cover attached to the gap pad. The cooling interface module thermally couples the tab to the cooling interface block.

## Description

### INTRODUCTION

Some information processing devices are configured to removably receive pluggable modules. These pluggable modules are designed to be easily insertable and removable into the computing system, often in a hot pluggable manner, in contrast to other more permanent components of the system, such as a motherboard or central processing unit (CPU), which generally remain in place once installed until/unless a repair or replacement is needed. Examples of pluggable modules include pluggable media drives (e.g., solid State Drives (SSD)), pluggable optical transceivers (e.g., Quad Small Form-Factor Pluggable (QSFP) connectors, Octal Small Form-Factor Pluggable (OSFP) connectors, etc.), network interface cards (NICs), PCIe cards, etc. The information processing device generally has a receptacle defining one or more bays to removably receive the pluggable modules, with the bays comprising connectors to mate with complementary connector(s) of the pluggable module when it is inserted into the bay to establish an electronic, optical, or other connection through which signals can be communicated between the pluggable module and other components of the system (such as the CPU).

### BRIEF DESCRIPTION OF THE DRAWINGS

The present disclosure can be understood from the following detailed description, either alone or together with the accompanying drawings. The drawings are included to provide a further understanding of the present disclosure and are incorporated in and constitute a part of this specification. The drawings illustrate one or more examples of the present teachings and together with the description explain certain principles and operations. In the drawings:
FIG. 1 is a block diagram illustrating an example information processing system and an example module cooing assembly thereof.
FIG. 2 is a block diagram illustrating another example information processing system and another example module cooing assembly thereof.
FIG. 3 is a block diagram illustrating another example information processing system and another example module cooing assembly thereof.
FIG. 4 is perspective view of another example information processing system and another example module cooing assembly thereof.
FIG. 5 is a perspective view of a portion of the system of FIG. 4 in isolation, comprising cooling interface blocks and cooling interface modules attached thereto.
FIG. 6 is a perspective view of one of the cooling interface blocks of the system of FIG. 4 in isolation.
FIG. 7 is a partially exploded perspective view of one of the cooling interface blocks of the system of FIG. 4 in isolation.
FIG. 8 is a perspective view of another portion of the system of FIG. 4 in isolation, comprising a pluggable module with thermal transfer assembly attached thereto.
FIG. 9 is a side view of the pluggable module of FIG. 8 in isolation.
FIG. 10 is a perspective view of a portion of the system of FIG. 4, comprising a cooling interface block, a module cage, and pluggable modules installed in the module cage and engaged with the cooling interface block.
FIG. 11 is a side sectional view of a portion of the system of FIG. 4, with section taken along line 11-11 in FIG. 10.
FIG. 12 is perspective view of a portion of another example information processing system and another example module cooing assembly thereof.

### DETAILED DESCRIPTION

Information processing devices, such as computers and networking devices, generate heat when in use, and cooling systems may be utilized to remove heat from components of the information processing devices to keep them within desired operating temperatures. In a system which utilizes air flows to cool components, it is relatively straightforward to cool pluggable modules using these air flows, notwithstanding the fact that the pluggable modules are non-permanent parts which are insertable/removable in the system. For example, the bays which receive the pluggable modules may be disposed in the airflow paths such that, if a pluggable module is installed in a bay, portions of the existing air flows in the system will naturally flow through the pluggable module, and when a module is absent from a bay a so-called blank can be installed in the bay in lieu of the pluggable module to regulate airflow in the absence of the module. Thus, the pluggability/removability of the pluggable module does not pose a serious obstacle to air cooling.

However, it may be desired in some circumstances to be able use liquid cooling to cool pluggable modules, and this can be much more challenging than air cooling the pluggable modules due to the pluggability/removability thereof. It may be desired to liquid cool pluggable modules, for example, because liquid may have greater cooling capacity than air, thus enabling more powerful (and hence hotter) pluggable modules to be used. In addition, in some circumstances, it may be desired to have air cooling removed entirely from an information processing system such that the system is liquid cooled only, and if such a system is to have pluggable modules then a solution for liquid cooling those pluggable modules is needed. Using liquid cooling only throughout a system may have benefits such as allowing for more power density (due to the greater cooling capacity of liquid), reduced power consumption and reduced noise due to omission of fans, and reduced complications from dust or other adverse environmental conditions because air is not flowing through the system.

As noted above, it can be very challenging to cool pluggable modules with most liquid cooling techniques. This is because in most liquid cooling techniques, liquid coolant does not flow freely throughout the system, such as air does in air-cooled systems, but instead the liquid coolant is carefully contained within conduits, cold plates, and other liquid cooling infrastructure. (Immersion cooling techniques are an exception to this, but those techniques have their own challenges, and are not suitable for all applications). Because the liquid coolant is contained in the liquid cooling infrastructure in the system, when a pluggable module is installed in a bay, the liquid coolant does not naturally flow into the pluggable modules in the way that air would in an air cooled system. Instead, some sort of removable connection between the pluggable modules and the liquid coolant in the system must be made, and this connection needs to be easily made or broken when the pluggable modules are installed or removed.

One approach to making this connection between pluggable modules and the liquid coolant is to fluidically connect liquid cooling infrastructure in the module to liquid cooling infrastructure in the system, for example by quick-disconnects (QD) or other fittings, such that the liquid coolant actually flows through the pluggable module. However, this approach can be costly and complicated, as expensive liquid cooling infrastructure needs to be provided for each pluggable module. Moreover, the QDs or other fittings pose a risk of leakage, making this approach unsuitable for some applications.

Another approach is to arrange a cold plate in the system such that, when the pluggable module is installed, it comes into contact with the cold plate, such that heat from the pluggable module can be transferred into the liquid coolant via conduction through the cold plate (without the liquid ever actually entering the pluggable module). However, in order to provide sufficient cooling by this approach, there needs to be a good thermal interface between the component to be cooled and the cold plate, and it can be difficult to establish a good thermal interface with parts that are designed to be easily pluggable and removable. In particular, the surfaces which are to contact one another are generally not perfectly smooth and may not be perfectly aligned, which can lessen heat transfer rates. With more permanent components, like the CPU, a good thermal interface can be established notwithstanding such surface imperfections because the cold plate is permanently attached directly to the component and therefore relatively high contact pressures can be used and a thermal interface material (TIM) (such as gap pads or thermal greases/pastes) can be applied between the contacting surfaces. The high contact pressures can overcome initial misalignment of the contacting surface and compensate for some surface imperfections thereof, thus improving heat transfer rates. Moreover, the TIM may fill in gaps between the contacting surfaces, which arise due to surface imperfections, thus further improving heat transfer. However, with a pluggable module, the cold plate cannot be attached to the module because this would interfere with the ability to remove the pluggable module from the system, and the use of high contact pressures and TIMs are also generally not feasible with such pluggable modules.

One reason why use of a TIM to improve heat transfer rates may not be feasible with pluggable modules is that as a pluggable module is inserted or removed into a receptacle (which may occur repeatedly across the module's lifetime), contact between the pluggable module and the TIM (particularly sliding contact) can result in damage to and/or removal of the TIM. For example, if the TIM is a gap pad, the contact may tear or rub off the gap pad. Or, if the TIM is a thermal grease or paste, the contact may wipe off the TIM. Thus, the damaged or removed TIM may not be effective at improving heat transfer. Furthermore, even if the TIM remains effective for one, or a few, insertions/removals, it may wear away eventually and thus may need to be reapplied periodically, which increases costs and complexity. In addition, some thermal greases or pastes can be quite messy, with the potential to spill out during insertion or to leave a residue on the removed pluggable module after removal. Thus, while the use of a TIM can improve thermal performance, it may not be a feasible solution for pluggable modules in some applications.

One reason why use of high contact pressures to improve heat transfer rates may not be feasible with pluggable modules is that achieving high contact pressures may require the user to supply very large forces to insert or remove the module (this is particularly true with a so-called "dry" interface, without any TIM). In some systems, the magnitude of the insertion/removal forces that would be required to achieve sufficiently high contact pressures to provide desired rates of heat transfer would exceed the limits of what a user can comfortably supply. Thus, relying on high contact pressure to establish a good thermal interface may not be feasible with pluggable modules in some applications.

Accordingly, the requirement to be able to easily insert the pluggable modules into and remove the pluggable modules from the system can make it difficult to liquid cool the pluggable modules.

The present disclosure addresses these issues by providing a pluggable module cooling assembly comprising a cooling interface block which is disposed in the system adjacent to a bay and thermally coupled to liquid coolant of a liquid cooling subsystem, a heat transfer device attached to the pluggable module, and a cooling interface module which interfaces between the two when the pluggable module is installed in the bay. The cooling interface block comprises a slot, which is recessed along an insertion direction of the pluggable module, and the heat transfer device comprises a tab protruding along the insertion direction, with the tab being configured to be inserted into the slot as the pluggable module is installed in the bay. Furthermore, the cooling interface module is configured to sit between the tab and the slot and to thermally couple with both when the pluggable module is installed. Thus, the pluggable module is removably thermally coupled with the liquid coolant via the engagement between the tab, the cooling interface module, and the cooling interface block.

The cooling interface module provides for a dry thermal interface between the slot and the tab, meaning an interface in which the moving engagement surfaces do not have any TIM therebetween. Moreover, the cooling interface module may compliantly conform to the surface contours of the tab and slot, thus allowing for a good thermal interface to be established therebetween notwithstanding surface imperfections, in a manner similar to how a TIM would improve heat transfer rates. However, unlike a TIM, the cooling interface module may be relatively robust and thus may resist being damaged or removed during the insertion removal. Thus, the cooling interface module can allow for desired heat transfer rates to be achieved even with relatively low contact pressures between the mating parts, thus avoiding the problem of high insertion/removal forces for the modules.

The cooling interface module comprises a thermal gap pad with a thin protective cover attached thereto, with the protective cover being formed from a thermally conductive material which is relatively robust (e.g., strong, hard, ductile) such as a thin metal sheet/foil. In some examples, the cooling interface module may be attached to the cooling interface block and is positioned in the slot even when a pluggable module is not present. In such examples, the gap pad is positioned between the cooling interface block and the protective cover and is in contact with both, and when the tab is inserted into the slot, the tab makes sliding contact with the protective cover. In other examples, the cooling interface module is attached to the tab and thus is present in the slot only when the pluggable module is installed. In such examples, the gap pad is positioned between the tab and the protective cover and in contact with both, such that when the tab is inserted into the slot, the walls of the slot makes sliding contact with the protective cover.

When the tab is inserted into the slot, the gap pad is compressed between the slot and the tab. Elastic restoring forces in the compressed thermal gap pad push the protective cover against the opposing surface of the slot or tab, and because the protective cover is thin and malleable this pressure conforms the protective cover to the opposing surface. This conformation of the protective cover to the opposing surface can compensate for misalignment between the surfaces of the slot and tab or other surface imperfections thereof, thus allowing for more surface contact area and a better thermal interface.

Moreover, the compliance of the protective cover against the opposing surface can be achieved without requiring high contact pressures between the protective cover and the opposing surface. The protective cover may be relatively thin and malleable, and thus may conform rather easily to the opposing surface. Moreover, the restoring spring forces of the gap pad may be relatively modest. Thus, only relatively modest insertion or removal forces may be needed for inserting the tab into the slot.

Furthermore, when the tab is inserted into the slot, all of the sliding contact which occurs is contact between the protective cover and an opposing surface, with the gap pad being protected beneath the cover. In other words, unlike traditional TIMs which are exposed and thus come into sliding contact with the moving engagement surface, here the gap pad is not exposed and makes only stationary contact with the protective cover and slot/tab. Thus, the gap pad is prevented from being damaged or removed by the sliding contact. Moreover, unlike a TIM which might be damaged or removed by the sliding contact, the protective cover is made from a relatively robust material like steel or copper which can withstand the rigors of insertion/removal and without tearing or being rubbed off.

Thus, the cooling assemblies disclosed herein can allow for relatively good thermal interfaces to be established without requiring excessive insertion forces and without the difficulties associated with using traditional TIMs.

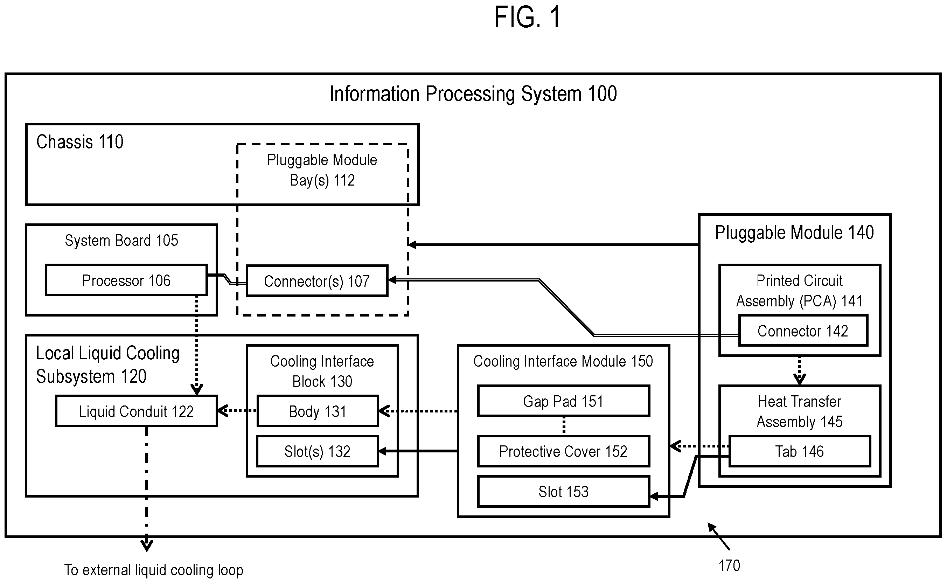

These and other examples will be described in greater detail below in relation to FIGs. 1-12.

FIGs. 1-3 illustrate example information processing systems 100, 200, and 300. The information processing systems 100, 200, and 300 comprise module cooling assemblies 170, 270, and 370. The module cooling assemblies 170, 270, and 370 may be used as part of the information processing systems 100, 200, and 300 and thus are illustrated in association therewith to aid understanding. However, portions of these systems, including in some cases the module cooling assemblies 170, 270, and 370 or portions thereof, could be provided separately from the other components of the information processing systems. Accordingly, some examples disclosed and claimed herein may comprise the information processing system 100, 200, or 300 as a whole, while other examples disclosed and claimed herein may comprise just portions of the systems 100, 200, or 300, such as the module cooling assemblies 170, 270, or 370 or portions thereof.

FIGs. 1-3 are schematic in nature and are not intended to illustrate shapes, sizes, or other structural details accurately or to scale. Components which are not illustrated in FIGs. 1-3 may also be included in some examples disclosed herein, or one or more components illustrated in FIGs. 1-3 may be omitted from some examples disclosed herein. In FIGs. 1-3, physical engagements are indicated conceptually by solid lines, electrical or optical connections are indicated by double solid lines, heat transfer paths are indicated by dotted lines, and liquid coolant flow paths are indicated by dot-dashed lines.

As shown in FIG. 1, the information processing system 100 comprises a system board 105, a chassis 110, one or more pluggable module bays 112, a local liquid cooling subsystem 120, a pluggable module 140, and a module cooling assembly 170.

The module cooling assembly 170 comprises an assembly of parts, some of which are also parts of the other components of the system 100. Specifically, the module cooling assembly 170 comprises the cooling interface block 130 (which is part of the local liquid cooling subsystem 120), the cooling interface module 150 (which can be part of the local liquid cooling subsystem 120 or the pluggable module 140), and the heat transfer assembly 145 (which is part of the pluggable module 140). These components of the module cooling assembly 170 will be described in greater detail below in conjunction with the other components of which they are a part.

The system board 105 comprises various information processing components, such as one or more processors 106 and other components, as would be familiar to those of ordinary skill in the art.

The chassis 110 supports and/or houses the system board 105, and may include various walls, brackets, or other support structures as would be familiar to those of ordinary skill in the art. The chassis 110 also includes a module cage or other receptacle which defines one or more pluggable module bays 112. These pluggable module bays 112 are defined by walls, brackets, and/or other support structures of the chassis 110 which form a receptacle in which pluggable modules such as the pluggable module 140 may be received. The pluggable module bays 112 may also include other elements which are not part of the chassis 110, such as the connectors 107, and therefore in FIG. 1 the block representing the bays 112 is partially within and partially without the block representing the chassis 110. The pluggable module bay 112 may include guiding/alignment and mounting features (not illustrated) to physically engage with the pluggable module 140, guide it into an installed position, and secure and support it once installed. Each pluggable module bay 112 may also include a connector 107, which mates with a corresponding connector 142 of the pluggable module 140 when the module 140 is installed in the bay 112. The connector 107 is electrically connected with the system board 105, thus allowing components thereof, such as the processor 106, to communicate with components of the pluggable module 140.

The local liquid cooling subsystem 120 comprises liquid cooling infrastructure, such as liquid conduits 122 and other infrastructure (e.g., valves, cold plates, pumps, etc.) which are local to the system 100 (e.g., provided within or attached to the chassis 110) and which circulate liquid coolant through the system 100. The liquid coolant carried by the liquid conduit 122 and other infrastructure may extract heat from components of the system 100, such as the processor 106. The local liquid cooling subsystem 120 may be connected to an external liquid cooling loop which circulates liquid coolant among multiple information processing systems. The external liquid cooling loop may include a coolant distribution unit (CDU) which comprises a heat exchanger to cool the liquid coolant (e.g., by exchanging heat with a facility coolant supply line), as well as manifolds and other infrastructure to distribute the liquid among the multiple information processing systems. The local liquid cooling subsystem 120 may receive the cooled coolant from the CDU, circulate the coolant through the system 100 where the liquid extracts heat from the components of the system 100 (such as processor 106). The local liquid cooling subsystem 120 then returns the now-warmed coolant to the CDU.

The local liquid cooling subsystem 120 also comprise the cooling interface block 130 mentioned above. The cooling interface block 130 may be thermally coupled to the liquid coolant of the subsystem 120. In some examples, the cooling interface block 130 is directly thermally coupled to the liquid coolant, meaning that there is direct contact between the liquid coolant and the cooling interface block 130. For example, the liquid coolant may flow through an interior channel or cavity the cooling interface block 130. In other examples, the cooling interface block 130 is indirectly thermally coupled to the liquid coolant, meaning that both are in mutual contact with one or more thermally conductive intermediaries which collectively form a thermally conductive path between the liquid coolant and the cooling interface block 130. For example, the cooling interface block may be in direct contact with a liquid conduit 122 which carries the liquid coolant, with the walls of the liquid conduit being thermally conductive and serving as the intermediary. In some examples, the same liquid coolant which is used to cool other components of the system 100 (such as processor 106) may be used to cool the cooling interface block 130 (and hence pluggable module 140).

The cooling interface block 130 comprises a body 131 and one or more slots 132. Each slot 132 is recessed from a surface of the body 131 along a recess direction which is parallel to an insertion direction of the pluggable module 140 into the bay 112. Walls of the body 131 which define the boundaries of the slots 132 may be referred to herein as walls of the slot 132. Each slot 132 is configured to receive a tab 146 of a corresponding pluggable module 140, as will be described in greater detail below. In some examples, multiple slots 132 which receive separate tabs 146 may be physically joined together forming one longer slot, but are treated herein conceptually as if they are separate slots 132 because they receive separate tabs 146. In some examples, multiple slots may be arranged in an array, which may include one dimensional array (e.g., a single row of multiple horizontally aligned slots 132 or a single column of multiple vertically aligned slots 132). or a two-dimensional array (e.g., multiple rows and multiple columns of slots 132).

The pluggable module 140 may be any pluggable module usable with an information processing device, such as a media drive, optical transceiver, NIC, PCIe card, or other pluggable module. The pluggable module 140 comprises a printed circuit assembly (PCA) 141 comprising one or more electronic components. The PCA 141 comprises a connector 142, which is configured to mate with the connector 107.

The pluggable module 140 also comprises a heat transfer assembly 145 thermally coupled to (e.g., in contact with) at least one heat generating component of the module 140, such as an electronic component of the PCA 141. The heat transfer assembly 145 comprise a body or assembly of bodies which collectively are thermally conductive (in some cases, highly thermally conductive) and configured to transfer heat between two end portions thereof. One end portion of the heat transfer assembly 145 is thermally coupled to the heat generating components and absorbs heat therefrom, whereas the other end is arranged to be thermally coupled with cooling interface block 130 (when the module 140 is installed in a bay 112) to release the heat into the block 130, with intermediate portions of the heat transfer assembly 145 conducting the heat between the two end portions.

The end portion of the heat transfer assembly 145 which is to be coupled with the block 130 comprises a tab 146 which protrudes from a rear end of the pluggable module 140. The rear end of the module 140 refers to the end which is inserted first into the bay 112. The protruding tab 146 is configured to be inserted into one of the slots 132 of the cooling interface block 130. The tab 146 is positioned at one end of the heat transfer assembly opposite from the end which is thermally coupled with the PCA 141. The heat transfer assembly 145 comprises a thermally conductive body (or group of bodies), such as a heat pipe (or group of heat pipes) or a solid block/bar of thermally conductive material (e.g., copper, aluminum). A heat pipe comprises a pipe-like structure made from a conductive material, such as copper, which has a hollow interior containing a working fluid and a wicking structure which are configured to transfer heat along a longitudinal dimension of the heat pipe by a repeating cycle of evaporation, convection, condensation, and wicking. That is, heat is absorbed by a liquid phase portion of the working fluid at the hot end (the end which is connected to PCA 141) resulting in evaporation of the heated working fluid into a vapor phase, the vapor phase working fluid then moves through convection to the cool end (i.e., the tab 146) whereupon the vapor phase working fluid condenses back into a liquid phase and in so doing releases heat into the outer casing at the cool end, and then the now condensed liquid phase is wicked back to the hot end to begin the cycle again.

The cooling interface module 150 comprises a gap pad 151, a protective cover 152, and a slot 153. As used herein, a gap pad refers to a thermal interface material (TIM) that is: solid (i.e., not a grease or paste), thermally conductive (in some examples, highly thermally conductive, as defined below), relatively compliant (meaning that the gap pad may compress and conform to the surfaces between which it is placed), and at least partially elastic (meaning that the gap pad generates restoring, spring like, forces when compressed which urge the gap pad back towards its uncompressed state). The protective cover 152 comprises a thin sheet or foil of low-friction, thermally conductive (in some cases, highly thermally conductive) material that is both conforming (malleable) and tear-resistant, such as stainless steel, copper, or other metal. The protective cover 152 may be attached to one face of the gap pad 151, for example via adhesive.

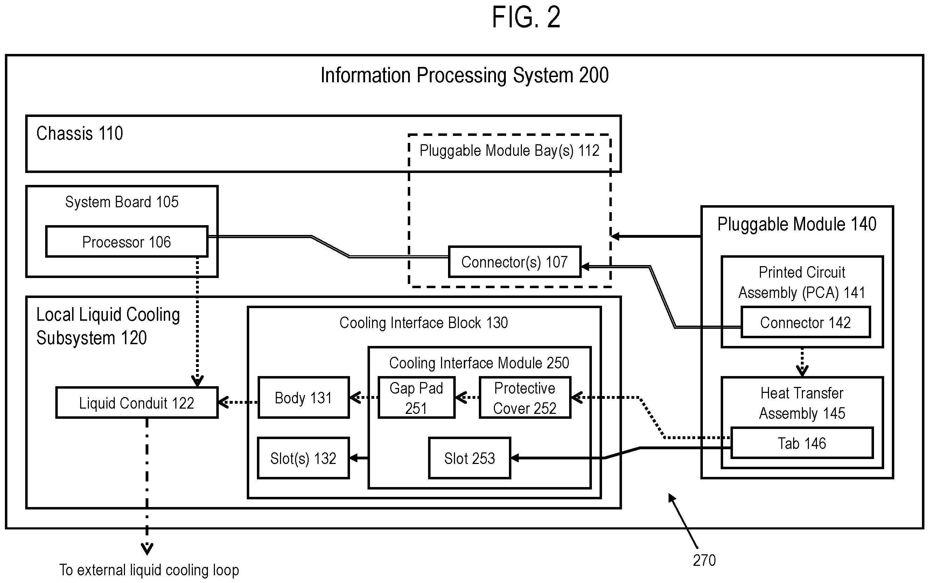

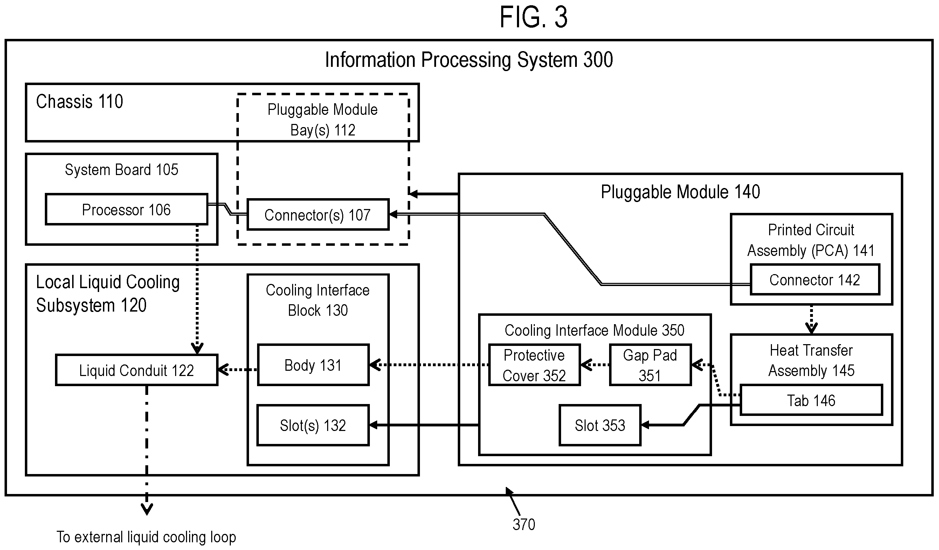

The gap pad 151 and the protective cover 152 have the form of relatively thin sheets (i.e., they have relatively broad lengths and widths compared to their thicknesses), and, when assembled together to form the cooling interface module 150, they are stacked or layered together in a U-shaped structure which has two parallel portions (called herein "legs") and a folded connecting portion connecting the two legs together. The volume between the two legs and the connecting portion may be referred to herein as the interior space of the U-shaped structure, and the slot 153 is defined within this interior space. One of the gap pad 151 and the protective cover 152 forms an outer layer of the U-shaped structure, which is exposed to an exterior environment and envelopes the other. The other of the gap pad 151 and the protective cover 152 forms an inner layer of the U-shaped structure, which bounds the slot 153 and is exposed to the interior space inside the U-shaped structure. In some examples, the gap pad 151 is the outer layer, such as in system 200 discussed below in relation to FIG. 2, while in other examples the protective cover 152 is the outer layer, such as in the system 300 discussed below in relation to FIG. 3. One way that the U-shaped structure may be formed is by stacking (layering) the gap pad 151 and the protective cover 152 to form a flat stacked structure and then folding one half of the flat stacked structure over the other. Another way that the U-shaped structure may be formed is by folding one of the gap pad 151 and the protective cover 152 first (prior to the joining of the gap pad 151 and the protective cover 152) and then folding the other one of the gap pad 151 and the protective cover 152 around the already folded one.

The cooling interface module 150 is configured to be inserted into the slot 132 of the cooling interface block 130, with the slot 153 of the cooling interface module 150 nesting within the slot 132 of the cooling interface block 130. The slot 153 is further configured to receive the tab 146 inserted therein, such that, when all parts are assembled, the tab 146 sits within the slot 153, which is in turn sitting within the slot 132, with the cooling interface module 150 disposed between the tab 146 and the walls of the slot 132. Specifically, one of the two legs of the U-shaped body sits between a top surface of the tab 146 and the top wall of the slot 132, whereas the other of the two legs of the U-shaped body sits between a bottom surface of the tab 146 and the bottom wall of the slot 132. This state is achieved when the pluggable module 140 is in an installed state within the bay 112. When the pluggable module 140 is not installed in the bay 112, the cooling interface module 150 may be connected to one of the cooling interface block 130 and the tab 146 but may be disconnected from the other, and then as the pluggable module 140 is installed in the bay 112 the remaining connections mentioned above are made as the tab 146 is inserted into the slot 132. In some examples, the cooling interface module 150 is inserted into the slot 153 first and then the tab 146 is inserted into the nested slots 153/132 concurrently during the module 140 installation, such as in system 200 described below, whereas in other examples tab 146 is inserted into the slot 153 first and then both the tab 146 and the cooling interface module 150 together are inserted into the slot 132 during the module 140 installation, such as in system 300 described below.

In each of the examples mentioned above, the gap pad 151 is compressed during the module 140 installation (e.g., either by the insertion of the tab 146 into slot 153 or by the insertion of the tab 146 and module 150 together into the slot 132), and the compressed gap pad 151 generates restoring forces which push the protective cover 151 against an opposing surface of either the tab 146 or the body 131 (depending on the example) causing the protective cover 151 to conform against that surface, thereby providing a good thermal interface between the cooling interface module 150 and that surface. Moreover, during the insertion of tab 146 into slot 132, sliding contact occurs between the protective cover 151 and the aforementioned opposing surface, but the protective cover 151 is made from a robust material (e.g., metal) and thus can resist being torn or rubbed away by the sliding contact. Moreover, the protective cover 151 is disposed between the opposing surface and the gap pad 151, and therefore the less robust gap pad 151 is protected by the protective cover 151 and does not experience the sliding contact, thus avoiding damage thereto.

Once the pluggable module 140 is in the installed state, the cooling interface module 150 thermally couples the tab 146 to the colling interface block 130, thereby forming a chain which thermally couples the PCA 141 to the liquid coolant of the liquid cooling subsystem 120. Specifically, as shown by the dotted lines in FIG. 1, heat flows from PCA 1410into the heat transfer assembly 145, through the heat transfer assembly 141 to the tab 146 thereof, from the tab 146 into the cooling interface module 150, from the cooling interface module 150 into the body 131, and from the body 131 into the liquid coolant carried by liquid conduit 122.

In some examples, the protective cover 152 covers the entirety of the gap pad 151. In some examples, the gap pad 151 is smaller than the protective cover 152. In some examples, multiple gap pads 151 are present, or, put another way, the gap pad 151 may be composed of multiple discrete parts which are not necessarily continuously connected.

In some examples, the protective cover 152 may have a coefficient of static friction less than 1.5, a thermal conductivity greater than 5 w/mK, and a tensile strength greater than 10000 psi. It is noted that the conformability and thermal conductivity of the protective cover 152 may depend not only on the intrinsic qualities of the material used to form the protective cover 152, but also on the thickness of the protective cover 152. For example, a relatively thin protective cover 152 may have a higher conductivity and greater conformability than a relatively thicker protective cover 152 of the same material. Many metals can be made into relatively thin sheets, foils, or films while retaining good tear resistance, and also tend to have good thermal conductivity and conformability (particularly when formed into a thin sheet or film). Thus, in some examples, the protective cover may be a thin metal sheet, foil, or film, such as a sheet, foil, or film made of copper, a copper alloy, nickel, steel, stainless steel, aluminum, an aluminum alloy, or a combination thereof. In such examples, the average thickness of the protective cover 152 may be as small as 0.0008 inches (0.020 millimeters) or, depending on the material, up to 0.006 inches (0.152 millimeters).

In particular, in some examples the protective cover 152 is copper and the average thickness thereof may be around 0.003 inches (0.076 millimeters). Copper has excellent thermal conductivity, which helps improve thermal transfer through the protective cover 152. In addition, copper is highly malleable, which allows the cover 152 to easily conform to the surface of the pluggable module when pressed against it by the restoring forces of the compressed gap pad 151, and this conforming of the cover 152 to the opposing surface improves the thermal interface therebetween and thus further improves the rate of heat transfer.

In other examples, the protective cover 152 is stainless steel, and the average thickness thereof may be around 0.001 inches (0.025 millimeters). Stainless steel has excellent durability, which allows it to be made thinner than other materials while still resisting tearing during insertion/removal of the pluggable module. This thinness allows for high thermal conductivity and conformability of the protective cover 152. In particular, although stainless steel may have lower intrinsic thermal conductivity than copper, the ability to make the protective cover 152 thinner can offset the lower intrinsic thermal conductivity of the steel and produce comparable (in some cases, better) overall conductivity.

Although metals in general, and copper and stainless steel in particular, are good candidates for the materials of the protective cover 152, examples are not so limited. In other examples, the protective cover may be manufactured from a thermally conductive plastic or other thermally conductive non-metallic material, such as thermally conductive tape. Regardless of the material, protective cover 152 may be disposed adjacent to gap pad 151 so as to protect gap pad 151 when a pluggable module140 is engaged.

As mentioned above, in some examples, the cooling interface module 150 is attached to the cooling interface block 130, such that the cooling interface module 150 may be considered a part thereof. For example, FIG. 2 illustrates an example information processing system 200 having this configuration, which is one example implementation of the system 100. As an implementation of the system 100, the system 200 has some components which are the same as those of the system 100, which are given the same reference numbers in FIG. 2 and in FIG. 1. The system 200 also has some components which are example implementations of corresponding components of the system 100, which are given reference numbers having the same last two digits (e.g., 150 and 250). More specifically, the module cooling assembly 270 and the cooling interface module 250 thereof are implementation examples of the module cooling assembly 170 and the cooling interface module 150 thereof.

Specifically, in this example of the module cooling assembly 270, the cooling interface module 250 is attached to the cooling interface block 130. Accordingly, in these examples, the cooling interface module 250 is present in the slot 132 before the module 140 is installed and remains in the slot 132 after the module 140 is removed. In some examples, adhesives, mechanical fasteners, or other fastening techniques are used to attach the module 250 to the block 130. In these examples, the gap pad 251 is the outermost layer of the U-shaped structure and is disposed in contact with the walls of the slot 132. The protective cover 252 is the innermost layer of the U-shaped module 250, facing the internal space of the slot 253. In other words, the gap pad 251 envelopes the protective cover 252. (As used herein, a first item "envelopes" a second item when the first item at least partially surrounds and is exterior to the second item).

Because in these examples the slot 253 is nested within the slot 132 prior to insertion of the tab 146 into either of the slots 132 or 253, as the pluggable module 140 is installed in the bay 112 the tab 146 is inserted concurrently into both slots 132 and 253 (in other words, insertion of the tab 146 into slot 253 results in the tab 146 concurrently being inserted into slot 132, and vice versa). During this insertion of tab 146 into the slots 132/253, the protective cover 252 comes into sliding contact with the tab 146, with the protective cover 252 protecting the gap pad 251 from damage or removal.

In these examples, when the module 140 is fully installed, the tab 146 is in contact with the protective cover 252 and the gap pad 251 is in contact with the walls of the slot 132, with the gap pad 251 being compressed between the protective cover 252 and the slot 132. In response to the compression, the gap pad 251 pushes the protective cover 252 inwardly against the tab 146 such that the protective cover conforms to the surface contours of the tab 146. Thus, in these examples, heat is transferred from the tab 146 into the protective cover 252, from the protective cover 252 into the gap pad 251, and from the gap pad 251 into the walls of the slot 132, as indicated by the dotted line arrows in FIG. 2.

In other examples, the cooling interface module 150 is attached to the tab 146, such that the cooling interface module 150 may be considered as a part of the pluggable module 140. For example, FIG. 3 illustrates an example information processing system 300 having this configuration, which is another example implementation of the system 100. As an implementation of the system 100, the system 300 has some components which are the same as those of the system 100, which are given the same reference numbers in FIG. 3 and in FIG. 1. The system 300 also has some components which are example implementations of corresponding components of the system 100, which are given reference numbers having the same last two digits (e.g., 150 and 350). More specifically, the module cooling assembly 470 and the cooling interface module 350 thereof are implementation examples of the module cooling assembly 170 and the cooling interface module 150 thereof.

Specifically, in this example of the module cooling assembly 370, the cooling interface module 350 attached to the tab 146, rather than to the cooling interface block 130. Thus, in the system 300, the tab 146 is received in the slot 353 prior to installation of the pluggable module 140 into the bay 112, and the cooling interface module 350 follows the pluggable module 140 when it is installed in or removed from the bay 112. In some examples, adhesives, mechanical fasteners, or other fastening techniques are used to attach the module 350 to the tab 146. In these examples, the gap pad 351 is the innermost layer of the U-shaped structure facing into the interior space of the slot 353 and is in contact with the tab 146 disposed in the slot 353. The protective cover 352 is the outermost layer of the U-shaped structure. In other words, in this example, the protective cover 352 envelopes the gap pad 351, which is opposite to the arrangement in the system 200. In some examples, the gap pad 351 may be attached to the tab 146, and the protective cover 352 may be attached to the gap pad 351, for example by adhesives for both.

Because in these examples the module 350 is attached to the tab 146, as the pluggable modules 140 is being installed in bay 112, the tab 146 and the cooling interface module 350 are concurrently inserted together into the slot 132 (in other words, as the tab 146 is inserted into the slot 132 the module 350 is concurrently inserted into the slot 132 along with the tab 146, and vice versa). During this insertion, the protective cover 352 contacts and slides against the walls of the slot 132.

In these examples, when the module 140 is fully installed, the tab 146 is in contact with the gap pad 351 and the protective cover 352 is in contact with the walls of the slot 132, with the gap pad 351 being compressed between the protective cover 352 and the tab 146. In response to the compression, the gap pad 351 pushes the protective cover 352 outwardly against the walls of the slot 132 such that the protective cover 352 conforms to the surface contours of the slot 132. Thus, in these examples, heat is transferred from the tab 146 into the gap pad 351, from the gap pad 351 into the protective cover 352, and from the protective cover 352 into the walls of the slot 132, as indicated by the dotted line arrows in FIG. 3.

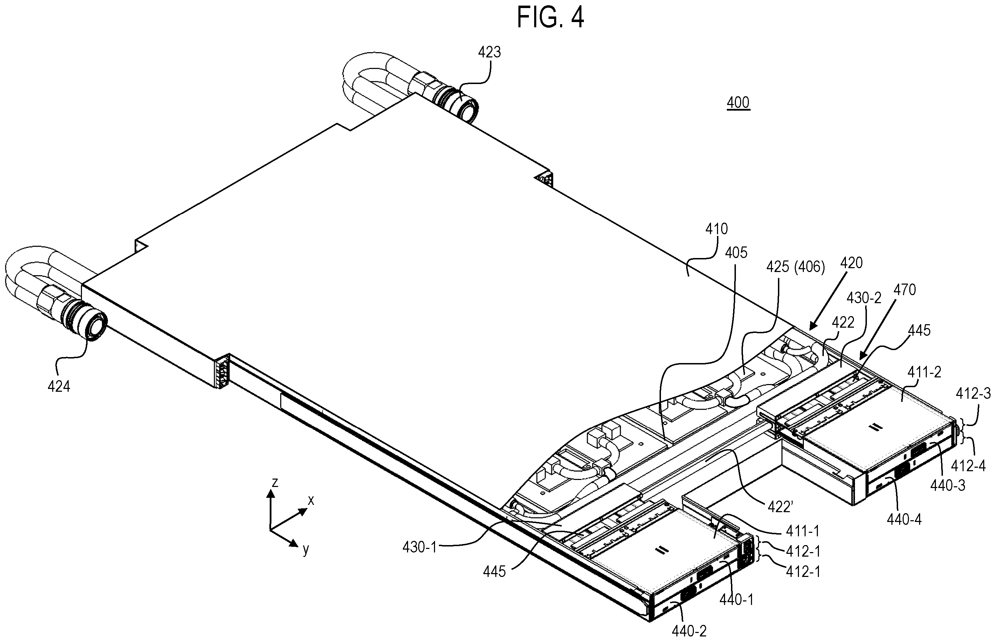

Turning to FIGs. 4-11, another example system 400 will be described. The system 400 is an example implementation of the systems 100 and 200 described above. Various components of the system 400 are similar to the components of the system 100 and 200 described above, and these similar components are given similar reference numbers herein (e.g., numbers having the same last two digits) and duplicative description of aspects of these components already described above may be omitted.

As shown in FIG. 4, the system 400 comprises a chassis 410, a system board 405 supported by and housed in the chassis 410, a local liquid cooling subsystem 420 supported by and housed in the chassis 410, two module cages 411 defining four pluggable module bays 412 in the chassis 410, four pluggable modules 440 removably receivable in the bays 412, and a module cooling assembly 470 to cool the modules 440 in the bays 412.

Note that some of the parts of the module cooling assembly 470 are also parts of the other components of the system 400. Specifically, the module cooling assembly 470 comprises the cooling interface block 430 and cooling interface modules 450, which are also part of the local liquid cooling subsystem 420, and the heat transfer assemblies 445, which are also parts of the pluggable modules 440. These components of the module cooling assembly 470 will be described in greater detail below in conjunction with the other components of which they are a part.

The system board 405 comprises various information processing components, such as one or more processors 406 and other components, as would be familiar to those of ordinary skill in the art. The processors 406 are not visible in FIG. 4 because they are disposed under the cold plates 425.

The chassis 410 comprises a base, a cover, two side walls, a front panel, a rear panel, and various internal walls brackets or other support structures, as would be familiar to those of ordinary skill in the art. The chassis 410 also comprises various module cages to house pluggable modules, including two module cages 411 to house the modules 440. As shown in FIG. 4, in the illustrated implementation, the module cages 411 are disposed at a rear side of the chassis 410 and make up part of the rear panel thereof. In other examples, the module cages 411 could be disposed elsewhere in the chassis 410, such as at a front panel thereof. In the illustrated example, there are two module cages 411. In other examples, there could be any other number of module cages 411 including one, three, or more. The chassis 410 may also include other cages (not visible) to support other modules, such as drive cages located at a front panel of the chassis 410.

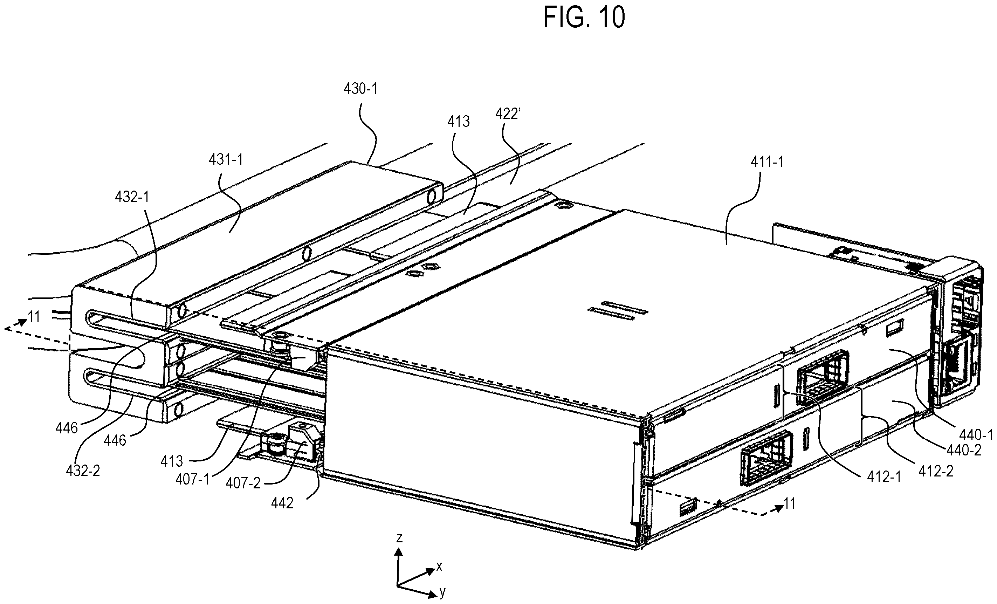

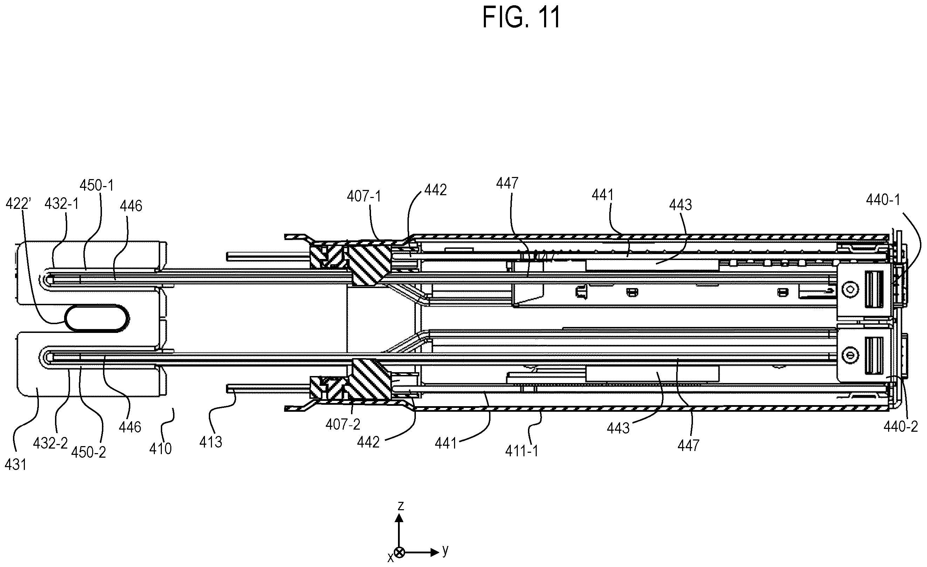

Each module cage 411 defines one or more bays 412 which are to receive pluggable modules 440. As shown in FIGs. 4 and 10, in the illustrated implementation each module cage 411 defines two bays 412, and thus the module cages 411-1 and 411-2 collectively comprise four bays 412 (i.e., bays 412-1, 412-2, 412-3, and 412-4). In other examples, a given module cage 411 could define any other number of bays 412 including one, three, or more. Moreover, although the module cages 411-1 and 411-2 are both identical in FIG. 4, in some examples, module cages 411 could differ from one another, such as by having different numbers of bays 412 or bays 412 configured to receive different types of modules. In the illustrated implementation, each module cage 411 may comprise a box-like housing with an open interior space. The pluggable module bays 412 include a portion of the open interior space of the cage 411 which receives one of the modules 440, as well as engagement features (not illustrated) which may be formed from or attached to walls of the cage 411. The engagement features are configured to physically engage with the pluggable module 440, guide it into an installed position, and secure and support it once installed. As shown in FIG. 10, each pluggable module bay 412 may also include a connector 407, which is attached to the cage 411 and positioned to mate with a corresponding connector 442 of the pluggable module 440 when the module 440 is installed in the bay 412. In the illustrated implementation, the connector 407 is attached to a bracket which is attached to and extends from a main housing of the cage 411. The connector 407 is electrically connected with the system board 405 by a cable 413, thus allowing components thereof, such as the processor 406, to communicate with components of the pluggable module 440 (note that only a portion of the cable 413 is depicted in FIGs. 10 and 11 to avoid obscuring other items).

Returning to FIG. 4, the local liquid cooling subsystem 420 comprises liquid cooling infrastructure, such as liquid conduits 422, cold plates 425, inlet 423, outlet 424, and other infrastructure (e.g., valves, cold plates, pumps, etc.) which are local to the system 400 (e.g., provided within or attached to the chassis 410) and which circulate liquid coolant through the system 400. The liquid coolant carried by the liquid conduit 422 and other infrastructure may extract heat from components of the system 400, such as the processor 406. For example, cold plates 425 may be mounted to the processors 406 and/or other components and liquid carried by one or more conduits 422 may flow through the cold plates 425 to absorb heat from the components. The local liquid cooling subsystem 420 may be connected to an external liquid cooling loop via inlet 423 and outlet 424, which receive cool liquid coolant and return warmed liquid coolant, respectively, from and to the external liquid cooling loop.

The local liquid cooling subsystem 420 also comprise one or more cooling interface blocks 430. The cooling interface blocks 430 are positioned adjacent to the module cages 411 such that they can engage with the pluggable modules 440, as will be described below. In the implementation illustrated in FIG. 4, there are two cooling interface blocks 430, one for each module cage 411-namely, a cooling interface block 430-1 adjacent the module cage 411-1 and a cooling interface block 430-2 adjacent the module cage 411-2. In the illustrated implementation, each cooling interface block 430 is configured to engage with two pluggable modules 440 when they are inserted into the bays 412 of the adjacent module cage 411. In other examples, a different number of cooling interface blocks 430 may be provided, including one, three, or any number more. Moreover, in some examples, the cooling interface blocks 430 of a given system 400 may be different from one another, for example, with some engaging with different numbers of modules 440 than others. In particular, a given cooling interface block 430 could engage with one, two, three, or any number more of modules 440. For example, in some implementations, a single cooling interface block 430 may engage with all of the modules 440, instead of providing multiple cooling interface blocks 430 for separate groups of modules 440. Or, in still other examples, each cooling interface block 430 may engage but one module 440.

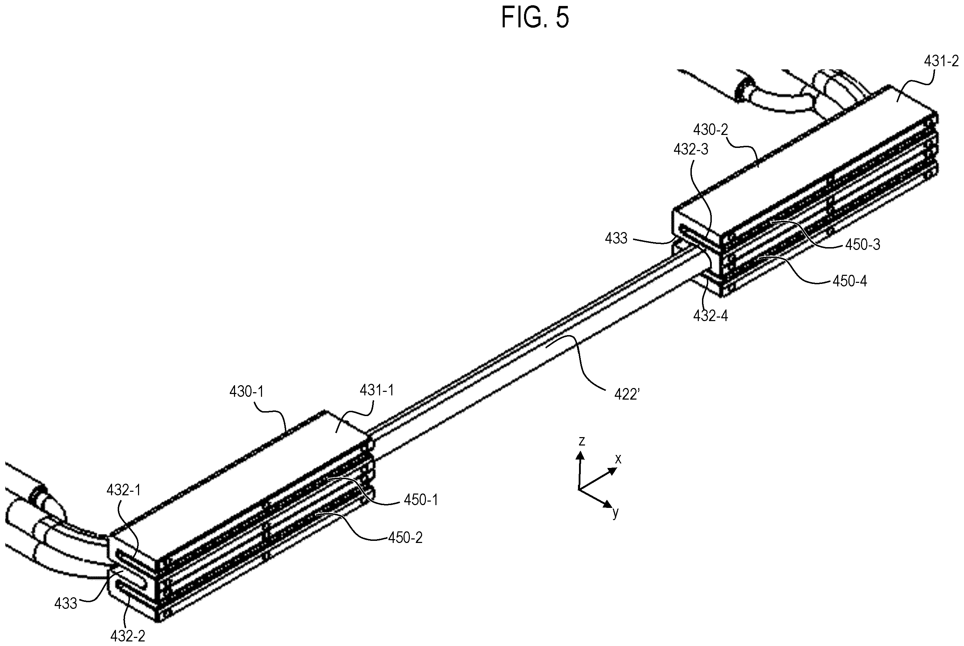

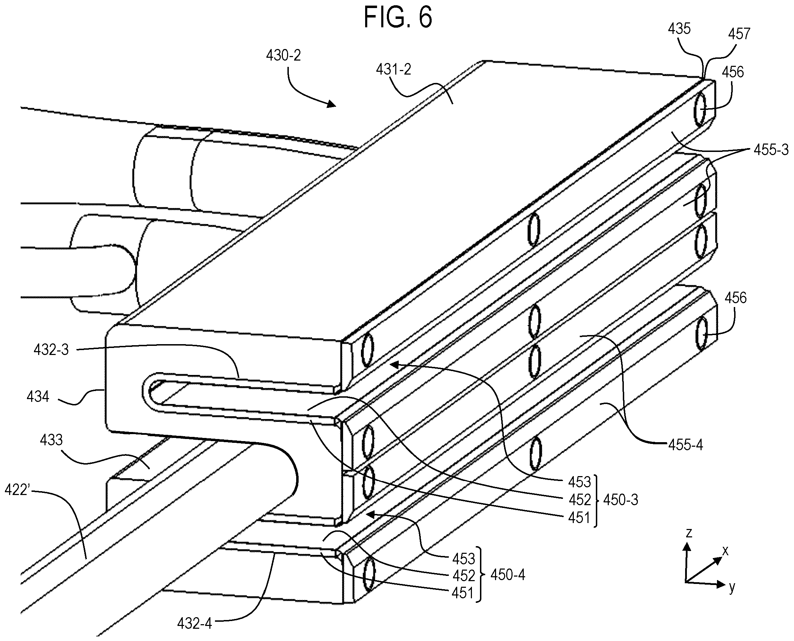

As shown in FIGs. 5 and 6, each cooling interface block 430 comprises a body 431, one or more slots 432, and a slot 433. The body 431 comprises thermally conductive material, such as copper, stainless steel, aluminum, or other metal, into which the slots 432 and slot 433 have been formed. In some examples, the body 431 is a solid, unitary (monolithic) body. In other examples, the body may be constructed from separate parts which are joined together by fasteners, welding, or other joining techniques.

As shown in FIG. 6, the slot 433 is horizontally recessed from one side 434 of the body 431 along a first recess direction (parallel to +y direction in FIG. 6). The slots 432, on the other hand, are horizontally recessed from an opposite side 435 of the body 431 along a second recess direction (-y direction) which is opposite from the first recess direction. The slots 433 and 432 also extend horizontally along extension directions which are perpendicular to the first and second recess directions (i.e., parallel to the x-axis).

The slot 433 has an opening in the side 434 of the body 431 through which one of the conduits 422, labeled 422' in FIGs. 4-6, can be inserted into the slot 433, as best seen in FIG. 6. The conduit 422' may be in contact with body 431 in the slot 433 so as to thermally couple the body 431 with the conduit 422'. For example, the slot 433 may have a height which is equal to or slightly smaller than that of the conduit 422' so that a tight fit is established therebetween. The conduit 422' may be made from a thermally conductive material, such as copper, and therefore the liquid coolant flowing through the conduit 422' is thermally coupled to the body 431 via this contact. Accordingly, heat can flow from the body 431 into the liquid coolant. The conduit 422' may, in some examples, carry liquid coolant which has previously cooled other components in the system, such as the processor 406. As show in FIG. 5, the same conduit 422' is coupled with both cooling interface blocks 430-1 and 430-2, but in other examples different conduits 422 could be coupled to different cooling interface blocks 430. In some examples, a TIM such as a thermal grease may be used in the slot 433 between conduit 422' and body 431, and because the conduit 422' does not usually need to be removable and the drawbacks of using TIMs on pluggable modules do not necessarily apply to the conduit 422'.

The slots 432 have openings in the other side 435 of the body, through which tabs 446 (described below) can be inserted, as shown in FIG. 10. In the illustrated example, there are two slots 432 per block 430, with each slot 432 being aligned with one of the bays 412 so as to be able to receive a tab 446 of a module 440 inserted into the corresponding bay 412. Specifically, in the block 430-1 a first slot 432-1 is aligned with bay 412-1 to receive module 440-1, whereas second slot 432-2 is disposed below first slot 431-1 in alignment with bay 412-2 to receive module 440-2. Similarly, in the block 430-2 a third slot 432-3 is aligned with bay 412-3 to receive module 440-3, whereas fourth slot 432-4 is disposed below slot 431-3 in alignment with bay 412-4 to receive module 440-4. In each block 430, the slot 433 is being positioned between the two slots 432, with a portion of the slot 433 being vertically overlapped by the slots 432.

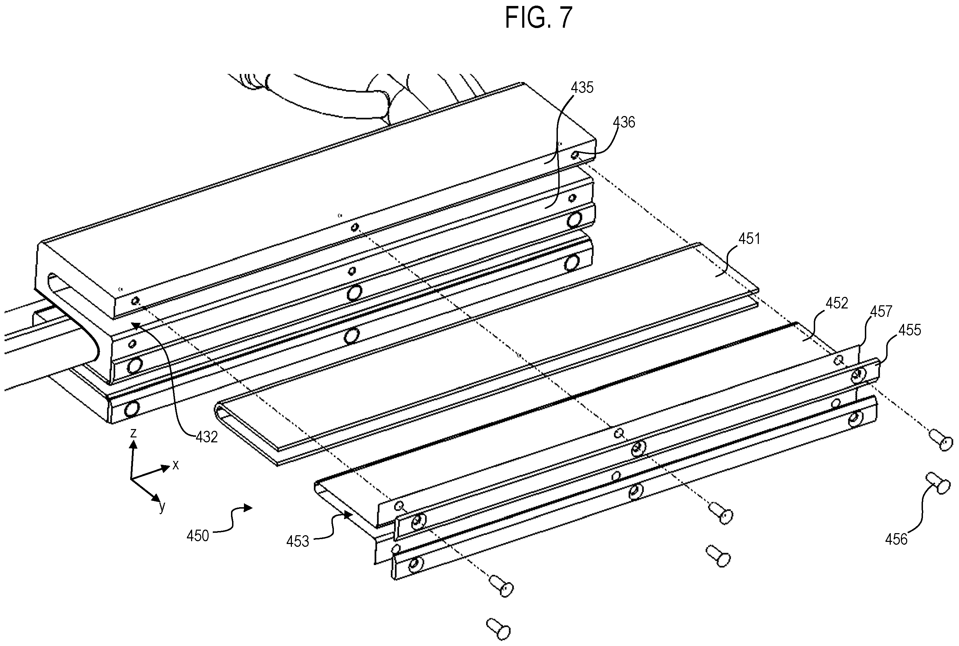

Turning to FIGs. 6 and 7, the cooling interface module 450 will be described. In this implementation example, the cooling interface module 450 is attached to the cooling interface block 430. More specifically, each cooling interface block 430 comprises a cooling interface module 450 for each slot 432 thereof. Thus, because each block 430 includes two slots 432 in the illustrated example, each block will also include two cooling interface modules 450, although in other examples different numbers of cooling interface modules 450 may be provided per block 430.

Each cooling interface module 450 comprises a gap pad 451, a protective cover 452, and a slot 453. The protective cover 452 comprises a thin sheet or foil of low-friction, thermally conductive material that is both conforming (malleable) and tear-resistant, such as steel, copper, or other metal. The protective cover 452 may be attached to one face of the gap pad 451, for example via adhesive. The gap pad 451 and the protective cover 452 are stacked in layers and then folded over to form a U-shaped structure, with two parallel portions and a connecting portion connecting the two parallel portions together. The slot 453 is formed between the two parallel portions of the U-shaped structure. In this example, the protective cover 452 is the innermost layer and the gap pad 451 is the outermost layer, with the protective cover 452 facing into the slot 453, as shown in FIGs. 6 and 7. The U-shaped body of the cooling interface module 450 is disposed in one of the slots 432 of the cooling interface block 430 as shown in FIG. 6, with the slot 453 of the cooling interface module 450 nesting within the slot 432 of the cooling interface block 430. Thus, in this example, the gap pad 451 is in contact with the body 431, specifically, with the walls of the slot 432, and the gap pad 451 sits between the protective cover 452 and the wall of the slot 432.

The slot 453 is further configured to receive a tab 446 of a pluggable module 440 inserted therein as shown in FIG. 10, with the tab 446 contacting and sliding against the protective cover. Once the module 440 is fully installed, the tab 446 will sit within the slot 453, which is in turn sitting within the slot 432, with the cooling interface module 450 disposed between the tab 446 and the walls of the slot 432. More specifically, when the module 440 is installed, the tab 446 is in contact with the protective cover 452 and the gap pad 451 is in contact with the walls of the slot 432, with the gap pad 451 being compressed between the protective cover 452 and the slot 432. In response to the compression, the gap pad 451 pushes the protective cover 452 inwardly against the tab 446 such that the protective cover 452 conforms to the surface contours of the tab 446. Thus, in these examples, heat is transferred from the tab 446 into the protective cover 452, from the protective cover 452 into the gap pad 451, from the gap pad 451 into the body 431 (i.e., into the walls of the slot 432), from the body 431 to the conduit 422', and from the conduit 422' into the liquid coolant.

As noted above, the cooling interface module 450 is attached to the body 431. In the illustrated example, mechanical fasteners are used to attach the module 250 to the body 431. As shown in FIG. 7, the protective cover 452 may include flanges 457 bent 90 degrees relative to the planar portions of the protective cover 452 which form the legs of the U-shaped body. In some examples, each protective cover 457 comprises a pair of the flanges 457. As shown in FIGs. 6 and 7, when the cooling interface module 450 is inserted into a slot 432 of the block 430, the flanges 457 remain outside the slot 432 and abut portions of the side 435 of the body 431. The cooling interface module 450 also comprises retention bars 455 (one pair per slot 432) which are fastened to the block via fasteners 456 (e.g., screws) which engage with fastener holes 436 in the side 435 of the body 431. Each flange 457 is sandwiched between the side 435 of the body 431 and one of the retention bars 455, thus securing the protective cover 452, and therefore the cooling interface module 450, to the body 431. The flanges 457 may also comprise holes through which the fasteners 456 may extend, but in some cases the protective cover may be sufficiently thin that the fasteners 456 may tear through these holes, and therefore the retention bars 455 may be used to prevent such tearing out.

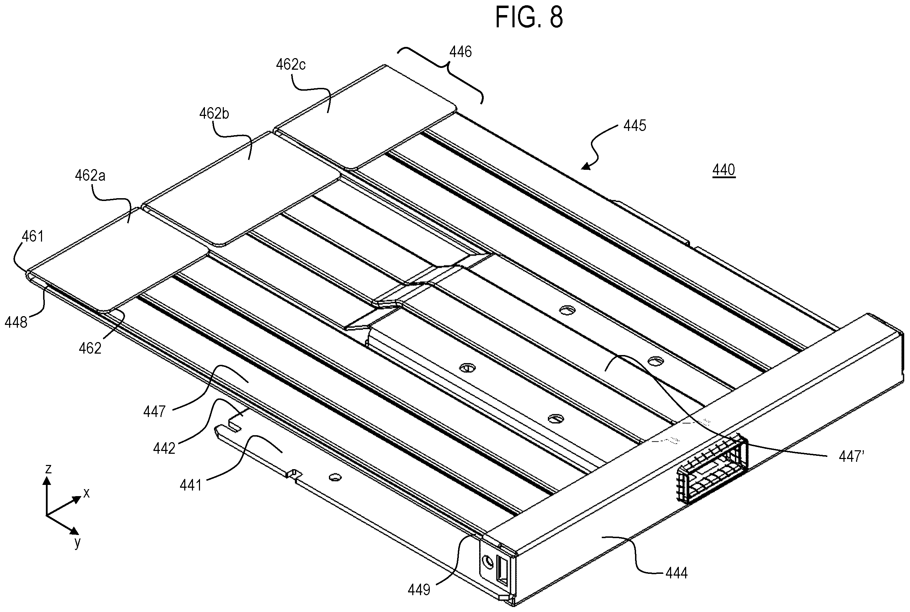

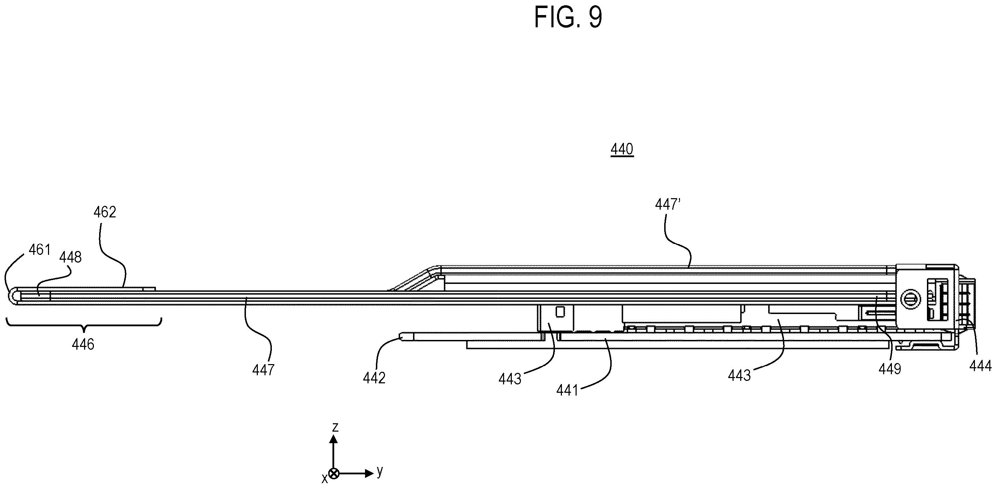

Turning to FIGs. 8 and 9, the pluggable module 440 will be described. The pluggable module 440 may be any pluggable module usable with an information processing device, such as a media drive, optical transceiver, NIC, PCIe card, or other pluggable module. The pluggable module 440 comprises a printed circuit assembly (PCA) 441 comprising one or more electronic components 443. The PCA 441 comprises a connector 442, which is configured to mate with the connector 407. In this example, the connector 442 is a PCB edge connector.

The pluggable module 440 also comprises a heat transfer assembly 445. As shown in FIG. 8, in this example the heat transfer assembly 445 comprises multiple heat pipes 447 which are attached to the PCA 441 and which are thermally coupled to (e.g., in contact with) at least one heat generating electronic component 443 of the module 440. The heat pipes 447 each extend from a first end portion 449 disposed closest to an end panel 444 of the module 440 to a second end portion 448 disposed farthest from the end panel 444. The heat pipes 447 are thermally coupled to the components 443 at or near the first end portion 449 thereof, or at some point between the first end portion 449 and the second end portion 448. The second end portion 448 protrudes beyond the edge of the PCA 441, allowing it to engage with one of the blocks 430 when the module 440 is installed in a bay 412.

Some components of the PCA 441 may have different heights than others, and therefore the portions of the heat pipes 447 which engage with those components may have different heights relative to one another. However, it may be desirable to have the second end portions 448 of all the heat pipes 447 at the same height relative to one another so as to allow them all to be received in the same slot 432. Accordingly, to allow the second end portions 448 to all be at the same height in spite of the varying component heights, some of the heat pipes 447, labeled 447' in FIG. 8, may be bent.

As shown in FIG. 8, the heat transfer assembly 445 also comprises a tab 446 which protrudes from a rear end of the pluggable module 440. The tab 446 is formed, in part, from the second end portions 448 of each of the heat pipes 447. The tab 446 may also be formed, in part, by a metal hem 462 which is formed on and around the second end portions 448 of the heat pipes 447. In particular, in some examples, groups of heat pipes may be attached to, or may include as an integral part thereof, a bottom metal layer, and this bottom metal layer may include a portion which extends rearward beyond the second end portions 448 of the heat pipes 447 which may be folded back over the second end portions 448 to rest on top thereof, thus forming the hem 462. A folded edge 461 of the hem 462 becomes a leading edge of the tab 446 which is first inserted into the slot 432/453. The folded edge 461 may be rounded to act as a lead-in feature to help guide the tab 446 into the slot 432/453.

In the example of FIG. 8, three heat pipes on one side of the module 440 are connected to the same bottom metal layer and this bottom layer is folded over them to form a hem 462a. Similarly, the three heat pipes on the opposite side of the module 440 are connected to the same bottom metal layer and this bottom layer is folded over them to form a hem 462c. Finally, the four heat pipes in the middle of the module 440 are connected to the same bottom metal layer and this bottom layer is folded over them to form a hem 462b. These three hems 462a, 462b, and 462c, together with the second end portions 448 of the heat pipes 447 covered by these hems 462, constitute the tab 446 of the heat transfer assembly 445. It is this tab 446 which is inserted into slots 453/432 of the block 430.

Although a specific number and arrangement of heat pipes 447 is illustrated in FIGs. 8-10, this is merely one example. In other examples, different numbers and/or arrangements of heat pipes 447 may be used in the heat transfer assembly 445. Moreover, in still other examples, heat pipes 447 are not used at all, and instead the heat transfer assembly 445 may comprise other heat transfer members, such as solid bars of conductive material (e.g., copper, aluminum), a single large vapor chamber, or some other heat transfer member. In particular, the heat transfer assembly 445 may comprise any thermally conductive body or assembly which is thermally coupled with the heat generating components of module 440and which has a protruding tab 446 that is positioned and shaped so as to be capable of insertion into and engagement with the slots 453/432.

FIGs. 10 and 11 illustrate two of the modules 440-1 and 440-2 installed in one of the module cages 411 and engaged with one of the cooling interface blocks 430-1. In this implementation, the modules 440-1 and 440-2 are installed in reversed orientation relative to one another. Thus, as shown in FIGs. 10 and 11, the connector 407-1 is positioned above the heat pipes 447 of the module 440-1, whereas the connector 407-2 is positioned below the heat pipes 447 of the module 440-1. In other words, the top module 440-1 is oriented so that the heat pipes 447 thereof extend under the corresponding connector 407-1, while the bottom module 440-2 is oriented 180 degrees opposite so that its heat pipes 447 extend over the corresponding connector 407-2. As shown in FIG. 11, the tabs 446 of the modules 440-1 and 440-2 are inserted into the slots 432-1 and 432-2, respectively, and are engaged with the cooling interface modules 450-1 and 450-2, respectively.

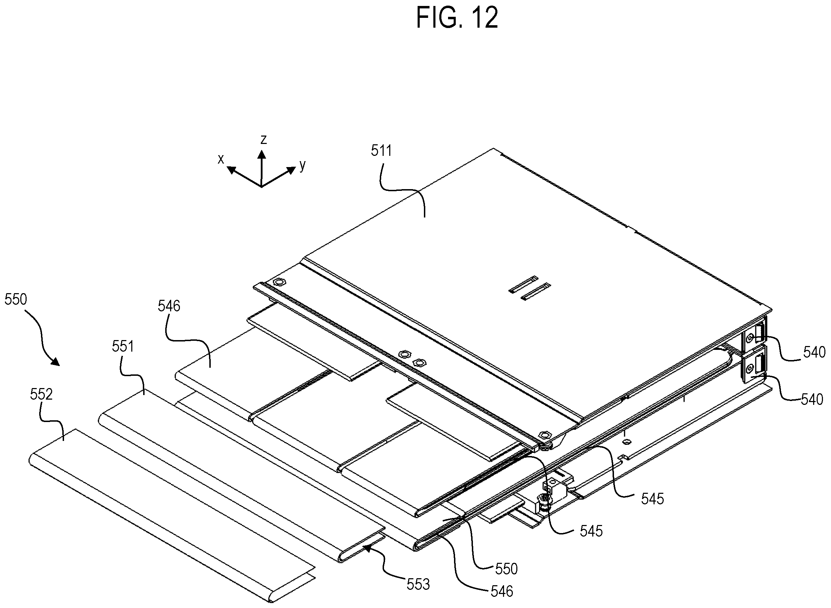

Turning to FIG. 12, another example system 500 will be described. The system 500 is an example implementation of the systems 100 and 300 described above. Thus, various components of the system 500 are similar to the components of the system 100 or 300 described above, and these similar components are given similar reference numbers herein (e.g., numbers having the same last two digits) and duplicative description of aspects of these components already described above may be omitted

As noted above, the system 500 is an example of the system 300, meaning that in the system 500 the cooling interface module is attached to the tab of the heat transfer assembly of the pluggable module, instead of being attached to the cooling interface block as in the system 400. This will be explained in greater detail below.

The system 500 comprises a module cage 511, in which may be disposed pluggable modules 540. The pluggable modules 540 may comprise thermal transfer assemblies 545, which may be similar to the thermal transfer assembly 545. The system 500 also comprises a cooling interface module 550, which is attached to the tab 546 of the thermal transfer assembly 545. The system 500 also comprises a chassis, a system board, a local liquid coolant subsystem, and a cooling interface block, which are omitted from FIG. 12 to simplify the description. The chassis, a system board, a local liquid coolant subsystem may be similar to the similarly named components of the system 400 described above, and thus duplicative description thereof is omitted. The cooling interface block of the system 500 may also be similar to the cooling interface block 430 of the system 400, except that the cooling interface block of the system 500 does not include the cooling interface module attached thereto and therefore the attachment features mentioned in relation to cooling interface block 430 (e.g., fastener holes 436, retention bars 455, and fasteners 456) may be omitted from the cooling interface block of the system 500.

Like the cooling interface module 450, the cooling interface module 550 comprises a gap pad 551, a protective cover 552, and a slot 553. The gap pad 551 and protective cover 552 are layered together and folded into a U-shaped body, with the slot 553 being defined between two legs of the body. However, the cooling interface module 550 differs from the cooling interface module 450 in that the cooling interface module 550 is attached to the tab 546 of the thermal transfer assembly 545 of the pluggable module 540, rather than being attached to a cooling interface block, and therefore the gap pad 551 is positioned as the innermost layer which faces into the slot 553. When the module 540 is fully assembled, the tab 546 is disposed in the slot 553 with the gap pad 551 being in contact with the tab 546, and the protective cover 552 envelops the gap pad 551. The gap pad 551 may be attached to the tab 546 and the protective cover 552 may be attached to the gap pad 551 (and thus indirectly to the tab 546). The protective cover 552 may also be attached directly to the tab 546 in some examples. The attachment of the gap pad 551 to the tab 546 and/or the attachment of the protective cover 552 to the gap pad 551 and/or the tab 546 may be by way of adhesives, mechanical fasteners, or other fastening techniques. In the example of FIG. 12, adhesives are used to attach gap pad 551 to tab and protective cover 552 to gap pad 551. In other examples, fasteners (e.g., screws) may be used. In other examples, the ends of the protective cover 552 may be soldered, welded, or otherwise joined to the tab 546. In some examples, gap pad 551 is not directly attached to tab 546 but is instead held against tab 546 by the protective cover 552, which is itself attached to tab 546.

In some examples, the slot 553 is formed before the tab 546 is inserted therein, e.g., by forming the cooling interface module 550 into a U-shaped structure and then inserting the tab 546 into the slot 553. In other examples, the slot 553 is formed simultaneously with the disposition of the tab 546 therein. For example, the gap pad 551 by itself may be folded around the tab 546, thus forming the slot 553 with the tab 546 already disposed therein upon its formation, and then the protective cover 552 may be folded around the gap pad 551 and tab 546. Or, as another example, the gap pad 551 and protective cover 552 may be assembled together first into a flat layered structure and then the flat layered structure may be folded around the tab 546, thus simultaneously forming the slot 553 with the tab 546 already disposed therein. Regardless of how the module 550 is assembled onto the tab 546, once this assembly is complete the protective cover 552 envelops both the gap pad 551 and the tab 546.

When the module 540 is inserted into a bay, the tab 546 and the module 550 attached thereto are concurrently inserted together in a slot of the cooling interface block. Moreover, because the protective cover 552 envelops the gap pad 551 and the tab 546, during this insertion the protective cover 552 (and in some cases, only the protective cover 552) makes sliding contact with the cooling interface block, thereby protecting the gap pad 551. When the module 540 is installed, the tab 546 is in contact with the gap pad 551 and the protective cover 552 is in contact with the walls of the slot of the cooling interface block, with the gap pad 551 being compressed between the protective cover 552 and the tab 546. In response to the compression, the gap pad 551 pushes the protective cover 552 outwardly against the cooling interface block such that the protective cover 552 conforms to the surface contours of the cooling interface block. Thus, in these examples, heat is transferred from the tab 546 into the gap pad 551, from the gap pad 551 into the protective cover 552, and from the protective cover 552 into the cooling interface module.

Cold Plate: As used herein, "cold plate" refers to a device that receives heat from a solid body via conduction (contact) and dissipates that heat into liquid coolant of a liquid cooling loop. The liquid coolant may be in direct contact with the cold plate (e.g., flowing through an interior chamber of the cold plate) or may be flowing through another device that is thermally coupled with the cold plate.

Thermally Coupled: As used herein, to "thermally couple" two objects means to provide a thermally conductive pathway between the objects that allows heat to be conducted between the objects. Two objects may be considered to be thermally coupled if any of the following are true: (1) the two objects are in contact with one another (either direct contact, or contact via a TIM), (2) the objects are both thermally coupled to a thermally conductive intermediary (e.g., a heat pipe, heat spreader, etc.) (or to a chain of thermally conductive intermediaries thermally coupled together), or (3) a heat transfer coefficient between the two objects is 10 W·m⁻²·K⁻¹ or greater.

Thermally conductive: An object, device, or assembly (which may comprise multiple distinct bodies that are thermally coupled, and may include multiple different materials), is "thermally conductive" between two thermal interfaces if any one of the following is true: (1) a heat transfer coefficient between the thermal interfaces is 10 W·m⁻²·K⁻¹ or greater at any temperature between 0° C. and 100° C., (2) the object is continuous piece of a material that has a thermal conductivity (often denoted k, λ, or κ) between the two interfaces of 1 W·m⁻¹·K⁻¹ or greater at any temperature between 0° C. and 100° C., (3) the object is a heat pipe, vapor chamber, continuous body of copper, or continuous body of aluminum. Examples of materials whose thermal conductivity is greater than 1 W·m⁻¹·K⁻¹ between 0° C. and 100° C. include almost all metals and their alloys (e.g., copper, aluminum, gold, etc.), some plastics (e.g., TECACOMP^{®} TC compounds, CoolPoly^{®} D-series Thermally Conductive Plastics), and many other materials.

Highly thermally conductive: An object, device, or assembly (which may comprise multiple distinct bodies that are thermally coupled, and may include multiple different materials), is "highly thermally conductive" between two thermal interfaces if any one of the following is true: (1) a heat transfer coefficient between the thermal interfaces is 1000 W·m⁻²·K⁻¹ or greater at any temperature between 0° C. and 100° C., (2) the object is continuous piece of a material that has a thermal conductivity (often denoted k, λ, or κ) between the two interfaces of 100 W·m⁻¹·K⁻¹ or greater at any temperature between 0° C. and 100° C., (3) the object is a heat pipe, vapor chamber, continuous body of copper, or continuous body of aluminum. Examples of materials whose thermal conductivity is 100 W·m⁻¹·K⁻¹ or greater between 0° C. and 100° C. include certain types of copper, aluminum, silver, and gold.

In the description above, various types of electronic circuitry are described. As used herein, "electronic" is intended to be understood broadly to include all types of circuitry utilizing electricity, including digital and analog circuitry, direct current (DC) and alternating current (AC) circuitry, and circuitry for converting electricity into another form of energy and circuitry for using electricity to perform other functions. In other words, as used herein there is no distinction between "electronic" circuitry and "electrical" circuitry.

It is to be understood that both the general description and the detailed description provide examples that are explanatory in nature and are intended to provide an understanding of the present disclosure without limiting the scope of the present disclosure. Various mechanical, compositional, structural, electronic, and operational changes may be made without departing from the scope of this description and the claims. In some instances, well-known circuits, structures, and techniques have not been shown or described in detail in order not to obscure the examples. Like numbers in two or more figures represent the same or similar elements.

In addition, the singular forms "a", "an", and "the" are intended to include the plural forms as well, unless the context indicates otherwise. Moreover, the terms "comprises", "comprising", "includes", and the like specify the presence of stated features, steps, operations, elements, and/or components but do not preclude the presence or addition of one or more other features, steps, operations, elements, components, and/or groups. Components described as coupled may be electronically or mechanically directly coupled, or they may be indirectly coupled via one or more intermediate components, unless specifically noted otherwise. Mathematical and geometric terms are not necessarily intended to be used in accordance with their strict definitions unless the context of the description indicates otherwise, because a person having ordinary skill in the art would understand that, for example, a substantially similar element that functions in a substantially similar way could easily fall within the scope of a descriptive term even though the term also has a strict definition.

And/or: Occasionally the phrase "and/or" is used herein in conjunction with a list of items. This phrase means that any combination of items in the list-from a single item to all of the items and any permutation in between-may be included. Thus, for example, "A, B, and/or C" means "one of {A}, {B}, {C}, {A, B}, {A, C}, {C, B}, and {A, C, B}".

Elements and their associated aspects that are described in detail with reference to one example may, whenever practical, be included in other examples in which they are not specifically shown or described. For example, if an element is described in detail with reference to one example and is not described with reference to a second example, the element may nevertheless be claimed as included in the second example.

Unless otherwise noted herein or implied by the context, when terms of approximation such as "substantially," "approximately," "about," "around," "roughly," and the like, are used, this should be understood as meaning that mathematical exactitude is not required and that instead a range of variation is being referred to that includes but is not strictly limited to the stated value, property, or relationship. In particular, in addition to any ranges explicitly stated herein (if any), the range of variation implied by the usage of such a term of approximation includes at least any inconsequential variations and also those variations that are typical in the relevant art for the type of item in question due to manufacturing or other tolerances. In any case, the range of variation may include at least values that are within ±1 % of the stated value, property, or relationship unless indicated otherwise.

Further modifications and alternative examples will be apparent to those of ordinary skill in the art in view of the disclosure herein. For example, the devices and methods may include additional components or steps that were omitted from the diagrams and description for clarity of operation. Accordingly, this description is to be construed as illustrative only and is for the purpose of teaching those skilled in the art the general manner of carrying out the present teachings. It is to be understood that the various examples shown and described herein are to be taken as exemplary. Elements and materials, and arrangements of those elements and materials, may be substituted for those illustrated and described herein, parts and processes may be reversed, and certain features of the present teachings may be utilized independently, all as would be apparent to one skilled in the art after having the benefit of the description herein. Changes may be made in the elements described herein without departing from the scope of the present teachings and following claims.

It is to be understood that the particular examples set forth herein are nonlimiting, and modifications to structure, dimensions, materials, and methodologies may be made without departing from the scope of the present teachings.

Other examples in accordance with the present disclosure will be apparent to those skilled in the art from consideration of the specification and practice of the invention disclosed herein. It is intended that the specification and examples be considered as exemplary only, with the following claims being entitled to their fullest breadth, including equivalents, under the applicable law.

## Claims

1. An information processing system comprising:
a chassis defining a bay;
a system board supported by the chassis;
a local liquid cooling subsystem supported by the chassis and configured to circulate liquid coolant through the information processing system, the local liquid cooling subsystem comprising a cooling interface block thermally coupled to the liquid coolant, the cooling interface block comprising a slot;
a pluggable module removably received in the bay and comprising a heat transfer assembly comprising a tab removably received in the slot of the cooling interface block; and
a cooling interface module disposed in the slot between the tab and walls of the slot, the cooling interface module comprising a gap pad and a thermally conductive protective cover attached to the gap pad;
wherein the cooling interface module thermally couples the tab to the cooling interface block.

2. The system of claim 1,
wherein the cooling interface module is attached to the cooling interface block, the gap pad is in contact with the walls of the slot, the protective cover is in contact with the tab, and the gap pad envelopes the protective cover.

3. The system of claim 2,
wherein the gap pad is compressed between the protective cover and the walls of the slot and the gap pad causes the protective cover to conform to surface contours of the tab.

4. The system of claim 2,
wherein the cooling interface block comprises a body and the slot is recessed from a first side of the body; and
wherein the cooling interface module is attached to the first side of the body.

5. The system of claim 3,
wherein the protective cover comprises a pair of flanges folded over the first side of the body; and
wherein the cooling interface block comprises a pair of retention bars attached to the first side of the body by fasteners with the flanges retained between the retention bars and the first side of the body.

6. The system of claim 2,
wherein the gap pad and the protective cover are layered together and folded into a U-shape to define a second slot configured to receive the tab inserted therein; and
wherein the second slot is nested within the slot of the cooling interface block prior to insertion of the tab into the slot such that, as the tab is inserted into the slot, the tab is concurrently inserted into the second slot.

7. The system of claim 1,
wherein the cooling interface module is attached to the tab, the protective cover is in contact with the walls of the slot, the gap pad is in contact with the tab, and the protective cover envelopes the gap pad.

8. The system of claim 7,
wherein the gap pad is compressed between the protective cover and the tab and the gap pad causes the protective cover to conform to surface contours of the walls of the slot.

9. The system of claim 7,
wherein gap pad is folded around an end of the tab and attached to the tab by adhesives.

10. The system of claim 9,
wherein protective cover is folded around the gap pad and attached to the gap pad by adhesives.

11. The system of claim 7,
wherein the cooling interface module is attached to the tab prior to the tab being inserted in the slot such that, as the tab is inserted into the slot, the cooling interface module attached to the tab is concurrently inserted into the slot with the tab.

12. The system of claim 1,
wherein the local liquid cooling subsystem comprises a liquid conduit;
wherein the cooling interface block comprises a body and a third slot;
wherein the slot is recessed from a first side of the body and the third slot is recessed from a second side of the body; and
wherein the liquid conduit is disposed in the third slot in contact with the body, the liquid conduit thermally coupling the cooling interface block to the liquid coolant.

13. The system of claim 12, further comprising:
a second bay; and
a second pluggable module removably received in the second bay and comprising a second thermal transfer assembly comprising a second tab;
wherein the cooling interface block comprises a fourth slot recessed from the first side of the body and the second tab is removed received in the fourth slot.

14. The system of claim 13,
wherein the slot, third slot, and fourth slot vertically overlap one another with the third slot disposed between the slot and the fourth slot.

15. A pluggable module for removable installation in a bay of an information processing system, comprising:
a printed circuit assembly (PCA) comprising a connector configured to removably mate with a connector of the system in an installed state of the pluggable module in the bay;
a thermal transfer assembly thermally coupled to one or more electronic components of the PCA, the thermal transfer assembly comprising a tab protruding from the PCA and configured to be inserted into a slot of a cooling interface block of the system in the installed state of the pluggable module in the bay; and
a cooling interface module attached to the tab and comprising a gap pad and a thermally conductive protective cover,
wherein the gap pad is attached to and in contact with the tab,
wherein the protective cover is attached to, in contact with, and envelops the gap pad,
wherein the cooling interface module is configured to, in an installed state of the pluggable module in the bay, thermally couple the tab to the cooling interface block.

16. The pluggable module of claim 15,
wherein the gap pad is folded around an end of the tab, and the protective cover is folded around the gap pad and attached to the gap pad.

17. The pluggable module of claim 15, wherein thermal transfer assembly comprises a plurality of heat pipes.

18. The pluggable module of claim 17, wherein tab comprises one or more metal hems at ends of the heat pipes.

19. An information processing system comprising:
a chassis defining a bay configured to removably receive a pluggable module;
a system board supported by the chassis;
a local liquid cooling subsystem supported by the chassis and configured to circulate liquid coolant through the information processing system, the local liquid cooling subsystem comprising a cooling interface block thermally coupled to the liquid coolant, the cooling interface block comprising a first slot; and
a cooling interface module attached to the cooling interface block and disposed in the first slot, the cooling interface module comprising a gap pad and a thermally conductive protective cover attached to the gap pad,
wherein the gap pad and the protective cover are folded such that the gap pad envelops the protective cover to define a second slot which is nested within the first slot, and
wherein the first slot and second slot are configured to removably receive a tab of a heat transfer assembly of the pluggable module in an installed state of the pluggable module in the bay such that the cooling interface module thermally couples the tab to the cooling interface block.

20. The system of claim 19,
wherein the cooling interface block comprises a body and the first slot is recessed from a first side of the body; and
wherein the protective cover comprises a pair of flanges folded over the first side of the body; and
wherein the cooling interface block comprises a pair of retention bars attached to the first side of the body by fasteners with the flanges retained between the retention bars and the first side of the body.
